(19)

Europäisches
Patentamt
European
Patent Office
Office européen
des brevets

(11) **EP 4 306 611 A1**

(12) **EUROPEAN PATENT APPLICATION**
published in accordance with Art. 153(4) EPC

(43) Date of publication:
**17.01.2024 Bulletin 2024/03**

(21) Application number: **22766990.0**

(22) Date of filing: **03.03.2022**

(51) International Patent Classification (IPC):
*C09K 11/00* (2006.01)   *C09K 11/62* (2006.01)
*B82Y 20/00* (2011.01)   *B82Y 40/00* (2011.01)
*H01L 33/50* (2010.01)

(52) Cooperative Patent Classification (CPC):
**B82Y 20/00; B82Y 40/00; C09K 11/00;**
**C09K 11/62; H01L 33/50;** Y02B 20/00

(86) International application number:
**PCT/JP2022/009144**

(87) International publication number:
**WO 2022/191032 (15.09.2022 Gazette 2022/37)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **08.03.2021 JP 2021036717**

(71) Applicants:
• **National University Corporation Tokai National**
  **Higher Education and Research System**
  **Nagoya-shi, Aichi 464-8601 (JP)**
• **OSAKA UNIVERSITY**
  **Suita-shi**
  **Osaka 565-0871 (JP)**
• **Nichia Corporation**
  **Anan-shi, Tokushima 774-8601 (JP)**

(72) Inventors:
• **TORIMOTO, Tsukasa**
  **Nagoya-shi, Aichi 464-8601 (JP)**
• **KAMEYAMA, Tatsuya**
  **Nagoya-shi, Aichi 464-8601 (JP)**
• **KUWABATA, Susumu**
  **Suita-shi, Osaka 565-0871 (JP)**
• **UEMATSU, Taro**
  **Suita-shi, Osaka 565-0871 (JP)**
• **IKAGAWA, Yohei**
  **Anan-shi, Tokushima 774-8601 (JP)**
• **OYAMATSU, Daisuke**
  **Anan-shi, Tokushima 774-8601 (JP)**
• **KUBO, Tomoya**
  **Anan-shi, Tokushima 774-8601 (JP)**

(74) Representative: **Vossius & Partner**
**Patentanwälte Rechtsanwälte mbB**
**Siebertstrasse 3**
**81675 München (DE)**

(54) **METHOD FOR PRODUCING SEMICONDUCTOR NANOPARTICLES, SEMICONDUCTOR NANOPARTICLES, AND LIGHT-EMITTING DEVICE**

(57)     Provided is a method of efficiently producing semiconductor nanoparticles that exhibit band-edge emission with a high band-edge emission purity. The method comprises performing a first heat treatment of a first mixture comprising a silver (Ag) salt, an indium (In) salt, a compound having a gallium-sulfur (Ga-S) bond, a first gallium halide, and an organic solvent, to obtain first semiconductor nanoparticles.

Fig. 1

**EP 4 306 611 A1**

**Description**

Technical Field

The present disclosure relates to: a method of producing semiconductor nanoparticles; semiconductor nanoparticles; and a light emitting device.

Background Art

Semiconductor particles having a particle size of, for example, 10 nm or smaller are known to exhibit a quantum size effect, and such nanoparticles are referred to as "quantum dots" (also referred to as "semiconductor quantum dots"). The "quantum size effect" refers to a phenomenon in which a valence band and a conduction band that are each regarded as continuous in bulk particles become discrete in nanoparticles when the particle size is on the nanoscale and the band-gap energy varies with the particle size.

Quantum dots are capable of absorbing light and converting the wavelength into a light corresponding to their band-gap energy; therefore, white light emitting devices utilizing emission of such quantum dots have been proposed (see, for example, Japanese Patent Publication Nos. 2012-212862 and 2010-177656). In addition, wavelength conversion films in which core-shell-structured semiconductor quantum dots that can exhibit band-edge emission and have a low-toxicity composition are used have been proposed (see, for example, Japanese Patent Publication No. 2010-177656). Further, sulfide nanoparticles have been studied as ternary semiconductor nanoparticles that can exhibit band-edge emission and have a low-toxicity composition, (see, for example, WO 2018/159699, WO 2019/160094, and WO 2020/162622).

Summary of Invention

Technical Problem

WO 2018/159699 discloses an efficient production method for obtaining semiconductor nanoparticles exhibiting band-edge emission by one-pot synthesis; however, there is room for further improvement in terms of the band-edge emission purity of the resulting semiconductor nanoparticles. Further, WO 2019/160094 and WO 2020/162622 disclose semiconductor nanoparticles exhibiting a high band-edge emission purity; however, there is room for further improvement in terms of efficient production method.

An object of an embodiment of the present disclosure is to provide a method of efficiently producing semiconductor nanoparticles that exhibit band-edge emission with a high band-edge emission purity.

Solution to Problem

A first embodiment is a method of producing semiconductor nanoparticles, the method comprising performing a first heat treatment of a first mixturecomprising a silver (Ag) salt, an indium (In) salt, a compound having a gallium-sulfur (Ga-S) bond, a first gallium halide, and an organic solvent, to obtain first semiconductor nanoparticles.

A second embodiment is a semiconductor nanoparticle comprising a first semiconductor that comprises silver (Ag), indium (In), gallium (Ga), and sulfur (S). A second semiconductor comprising Ga and S is disposed on a surface of the first semiconductor. The semiconductor nanoparticle exhibits band-edge emission with an emission peak wavelength in a wavelength range of 475 nm to 560 nm when irradiated with a light having a wavelength of 365 nm. The band-edge emission purity is 70% or higher, and an internal quantum yield of the band-edge emission is 15% or higher. In an energy dispersive X-ray analysis of the semiconductor nanoparticles, an intensity of a characteristic X-ray originating from Ga of the second semiconductor is higher than an intensity of a characteristic X-ray originating from Ga of the first semiconductor.

A third embodiment is a light emitting device comprising a light conversion member containing the above-described semiconductor nanoparticle and a semiconductor light emitting element.

Advantageous Effects of Invention

According to an embodiment of the present disclosure, a method of efficiently producing semiconductor nanoparticles that exhibit band-edge emission with a high band-edge emission purity may be provided.

Brief Description of Drawings

[FIG. 1] FIG. 1 shows exemplary emission spectra of the semiconductor nanoparticles of Example 1 and Comparative Example 1.
[FIG. 2] FIG. 2 shows exemplary emission spectra of the semiconductor nanoparticles of Examples 2, 3, 4, and 5.
[FIG. 3] FIG. 3 shows exemplary emission spectra for the semiconductor nanoparticles of Examples 6, 7, 8, and 9.
[FIG. 4A] FIG. 4A is an exemplary transmission electron microscope image showing the trajectory of a composition line analysis performed for the semiconductor nanoparticles of Example 2 by energy dispersive X-ray analysis.
[FIG. 4B] FIG. 4B is a diagram showing exemplary results of the composition line analysis performed for the semiconductor nanoparticles of Example 2 by an energy dispersive X-ray analysis.

Description of Embodiments

The term "step" used herein encompasses not only a discrete step but also a step that cannot be clearly distinguished from other steps, as long as the intended purpose of the step is achieved. When there are plural substances that correspond to a component of a composition, an indicated amount of the component contained in the composition means, unless otherwise specified, a total amount of the plural substances existing in the composition. Further, as an upper limit and a lower limit of a numerical range described in the present specification, the values exemplified for the numerical range can be arbitrarily selected and combined. Embodiments of the present invention will now be described in detail. It is noted here, however, that the below-described embodiments are merely examples of semiconductor nanoparticles and a method of producing the same that embody the technical idea of the present invention, and the present invention is not limited to the below-described semiconductor nanoparticles and method of producing the same.

Method of Producing Semiconductor Nanoparticles

The method of producing semiconductor nanoparticles includes a first step of performing a first heat treatment of a first mixture, which contains a silver (Ag) salt, an indium (In) salt, a compound having a gallium-sulfur (Ga-S) bond, a gallium halide, and an organic solvent, to obtain first semiconductor nanoparticles. As required, the method of producing semiconductor nanoparticles may further include other steps in addition to the first step.

First Step

The first step may include: a first mixing step of obtaining a first mixture that contains a Ag salt, an In salt, a compound having a Ga-S bond, a gallium halide, and an organic solvent; and a first heat treatment step of performing a first heat treatment of the obtained first mixture to obtain first semiconductor nanoparticles.

By using a compound having a Ga-S bond as a supply source of Ga and S that are included in the composition of the first semiconductor nanoparticles to be produced, it is made easy to control the composition of the first semiconductor nanoparticles. In addition, by using a gallium halide, it is made easy to control the particle size of the first semiconductor nanoparticles to be produced. Accordingly, it may be believed that semiconductor nanoparticles that exhibit band-edge emission with a high purity may be efficiently produced by a one-pot process.

In the first mixing step, a first mixture is prepared by mixing a Ag salt, an In salt, a compound having a Ga-S bond, a gallium halide, and an organic solvent. A mixing method in the first mixing step may be selected as appropriate from those mixing methods that are usually employed.

The Ag salt and the In salt in the first mixture may each be either an organic acid salt or an inorganic acid salt. Specifically, examples of the inorganic acid salt include nitrates, sulfates, hydrochlorides, and sulfonates, and examples of the organic acid salt include formates, acetates, oxalates, and acetylacetonates. The Ag salt and the In salt may each be preferably at least one selected from the group consisting of these acid salts, and the Ag salt and the In salt may each be more preferably at least one selected from the group consisting of organic acid salts such as acetates and acetylacetonates because these salts are highly soluble in organic solvents and thus allow reaction to proceed more uniformly. The first mixture may contain each of the Ag salt and the In salt singly, or in combination of two or more of the Ag salts and two or more of the In salts.

The Ag salt in the first mixture may contain a compound having an Ag-S bond because this may inhibit the generation of silver sulfide as a by-product in the below-described first heat treatment step. The Ag-S bond may be any of a covalent bond, an ionic bond, a coordinate bond, and the like. Examples of the compound having an Ag-S bond include Ag salts of sulfur-containing compounds, and the compound having an Ag-S bond may be an organic acid salt, inorganic acid salt, organic metal compound, or the like of Ag. Examples of the sulfur-containing compounds include thiocarbamic acids, dithiocarbamic acids, thiocarbonic acid esters, dithiocarbonic acid esters (xanthic acid), trithiocarbonic acid esters, thiocarboxylic acids, dithiocarboxylic acids, and derivatives thereof. Thereamong, at least one selected from the group consisting of xanthic acid and derivatives thereof is preferred because these compounds are decomposed at a relatively low temperature. Specific examples of the sulfur-containing compounds include aliphatic thiocarbamic acids, aliphatic dithiocarbamic acids, aliphatic thiocarbonic acid esters, aliphatic dithiocarbonic acid esters, aliphatic trithiocarbonic acid esters, aliphatic thiocarboxylic acids, and aliphatic dithiocarboxylic acids. Examples of the aliphatic groups in these sulfur-containing compounds include alkyl groups and alkenyl groups that have 1 to 12 carbon atoms. The aliphatic thiocarbamic acids may include dialkylthiocarbamic acids and the like, and the aliphatic dithiocarbamic acids may include dialkyldithiocarbamic acids and the like. The alkyl groups in the dialkylthiocarbamic acids and the dialkyldithiocarbamic acids may have, for example, 1 to 12 carbon atoms, preferably 1 to 4 carbon atoms. Two alkyl groups in the dialkylthiocarbamic acids and the dialkyldithiocarbamic acids may be the same or different. Specific examples of the compound having a Ag-S bond include silver dimethyldithiocarbamate, silver diethyldithiocarbamate (Ag(DDTC)), and silver ethyl xanthate (Ag(EX)).

The In salt in the first mixture may contain a compound having an In-S bond. The In-S bond may be any of a covalent bond, an ionic bond, a coordinate bond, and the like. Examples of the compound having an In-S bond include In salts of sulfur-containing compounds, and the compound having an In-S bond may be an organic acid salt, inorganic acid salt, organic metal compound, or the like of In. Examples of the sulfur-containing compounds specifically include thiocarbamic acids, dithiocarbamic acids, thiocarbonic acid esters, dithiocarbonic acid esters (xanthic acid), trithiocarbonic acid esters, thiocarboxylic acids, dithiocarboxylic acids, and derivatives thereof. Thereamong, at least one selected from the group consisting of xanthic acid and derivatives thereof is preferred because these compounds are decomposed at a relatively low temperature. Specific examples of the sulfur-containing compounds are the same as described above. Specific examples of the compound having an In-S bond include indium tris(dimethyldithiocarbamate), indium tris(diethyldithiocarbamate) $(In(DDTC)_3)$, indium chloro-bis(diethyldithiocarbamate), and indium ethyl xanthate $(In(EX)_3)$.

In the compound having a Ga-S bond that is contained in the first mixture, the Ga-S bond may be any of a covalent bond, an ionic bond, a coordinate bond, and the like. Examples of the compound having a Ga-S bond include Ga salts of sulfur-containing compounds, and the compound having a Ga-S bond may be an organic acid salt, inorganic acid salt, organic metal compound, or the like of Ga. Examples of the sulfur-containing compounds specifically include thiocarbamic acids, dithiocarbamic acids, thiocarbonic acid esters, dithiocarbonic acid esters (xanthic acid), trithiocarbonic acid esters, thiocarboxylic acids, dithiocarboxylic acids, and derivatives thereof. Thereamong, at least one selected from the group consisting of xanthic acid and derivatives thereof is preferred because these compounds are decomposed at a relatively low temperature. Specific examples of the sulfur-containing compounds are the same as described above. Specific examples of the compound having a Ga-S bond include gallium tris(dimethyldithiocarbamate), gallium tris(diethyldithiocarbamate) $(Ga(DDTC)_3)$, gallium chloro-bis(diethyldithiocarbamate), and gallium ethyl xanthate $(Ga(EX)_3)$. In the first mixture, the compound having a GaS bond may be contained singly, or in combination of two or more thereof.

Examples of the gallium halide in the first mixture include gallium fluoride, gallium chloride, gallium bromide, and gallium iodide, and the first mixture may contain at least one selected from the group consisting of these gallium halides. Further, the gallium halide may contain at least gallium chloride. These gallium halides may be used singly, or in combination of two or more thereof.

Examples of the organic solvent in the first mixture include: amines containing a hydrocarbon group having 4 to 20 carbon atoms, such as alkylamines and alkenylamines having 4 to 20 carbon atoms; thiols containing a hydrocarbon group having 4 to 20 carbon atoms, such as alkylthiols and alkenylthiols having 4 to 20 carbon atoms; and phosphines containing a hydrocarbon group having 4 to 20 carbon atoms, such as alkylphosphines and alkenylphosphines having 4 to 20 carbon atoms, and the first mixture preferably contains at least one selected from the group consisting of these organic solvents. These organic solvents may, for example, eventually modify the surfaces of the resulting first semiconductor nanoparticles. These organic solvents may be used in combination of two or more thereof and, for example, a mixed solvent of a combination of at least one selected from thiols containing a hydrocarbon group having 4 to 20 carbon atoms and at least one selected from amines containing a hydrocarbon group having 4 to 20 carbon atoms may be used. These organic solvents may also be used as a mixture with other organic solvent. When the organic solvent contains any of the above-described thiols and any of the above-described amines, a content volume ratio of the thiol with respect to the amine (thiol/amine) is, for example, higher than 0 but 1 or lower, preferably 0.007 to 0.2.

A content ratio of Ag, In, Ga, and S in the first mixture may be selected as appropriate in accordance with the intended composition. In this case, the content ratio of Ag, In, Ga, and S does not have to conform to a stoichiometric ratio. For example, a ratio (Ga/(In + Ga)) of the number of moles of Ga with respect to a total number of moles of In and Ga may be 0.2 to 0.95, 0.4 to 0.9, or 0.6 to 0.9. In addition, for example, a ratio (Ag/(Ag + In + Ga)) of the number of moles of Ag with respect to a total number of moles of Ag, In, and Ga may be 0.05 to 0.55. Further, for example, a ratio (S/(Ag + In + Ga)) of the number of moles of S with respect to a total number of moles of Ag, In, and Ga may be 0.6 to 1.6.

The first mixture may further contain an alkali metal salt. Examples of the alkali metal ($M^a$) include lithium (Li), sodium (Na), potassium (K), rubidium (Rb), and cesium (Cs), and the first mixture preferably contains Li because Li has an ionic radius close to that of Ag. Examples of the alkali metal salt include organic acid salts and inorganic acid salts. Specifically, examples of the inorganic acid salts include nitrates, sulfates, hydrochlorides, and sulfonates, and examples of the organic acid salts include acetates and acetylacetonates. Thereamong, organic acid salts are preferred because they are highly soluble in organic solvents.

When the first mixture contains an alkali metal salt, a ratio ($M^a$/(Ag + $M^a$)) of the number of alkali metal atoms with respect to a total number of Ag and alkali metal atoms may be, for example, lower than 1, and it is preferably 0.8 or lower, more preferably 0.4 or lower, still more preferably 0.2 or lower. Further, this ratio may be, for example, higher than 0, and it is preferably 0.05 or higher, more preferably 0.1 or higher.

In the first mixture, a content molar ratio of the gallium halide with respect to the Ag salt may be, for example, 0.01 to 1 and, from the standpoint of internal quantum yield, it may be preferably 0.12 to 0.45.

The concentration of the Ag salt in the first mixture may be, for example, 0.01 mmol/L to 500 mmol/L and, from the viewpoint of internal quantum yield, it may be preferably 0.05 mmol/L to 100 mmol/L, more preferably 0.1 mmol/L to 10 mmol/L.

In the first heat treatment step, a first heat treatment of the first mixture is performed to obtain first semiconductor nanoparticles. The temperature of the first heat treatment may be, for example, 200°C to 320°C. The first heat treatment step may include: the temperature raising step of raising the temperature of the first mixture to a temperature in a range of 200°C to 320°C; and the synthesis step of performing a heat treatment of the first mixture at a temperature in a range of 200°C to 320°C for a predetermined time.

The range to which the temperature is raised in the temperature raising step of the first heat treatment step may be 200°C to 320°C, preferably 230°C to 290°C. A temperature increase rate may be adjusted such that the highest temperature during the temperature raising does not exceed the intended temperature, and it is, for example, 1°C/min to 50°C/min.

The temperature of the heat treatment in the synthesis step of the first heat treatment step may be 200°C to 320°C, preferably 230°C to 290°C. The duration of the heat treatment in the synthesis step may be, for example, 3 seconds or longer, preferably 1 minute or longer, 10 minutes or longer, 30 minutes or longer, 60 minutes or longer, or 90 minutes or longer. Further, the duration of the heat treatment may be, for example, 300 minutes or shorter, preferably 180 minutes or shorter, or 150 minutes or shorter. The duration of the heat treatment in the synthesis step is defined that it starts at the time when the temperature reaches a temperature set in the above-described range (e.g., at the time when the temperature reaches 250°C in a case where the set temperature is 250°C), and ends at the time when an operation for lowering the temperature is carried out. By the synthesis step, a dispersion containing the first semiconductor nanoparticles may be obtained.

The atmosphere of the first heat treatment step is preferably an inert gas atmosphere, particularly an argon atmosphere or a nitrogen atmosphere. By using an inert gas atmosphere, the generation of an oxide as a by-product as well as the oxidation of the surfaces of the resulting first semiconductor nanoparticles may be reduced or prevented.

The method of producing semiconductor nanoparticles may further include, after the above-described synthesis step, the cooling step of lowering the temperature of a dispersion containing the resulting first semiconductor nanoparticles. The cooling step starts at the time when an operation for lowering the temperature is carried out, and ends at the time when the dispersion is cooled to 50°C or lower.

From the viewpoint of inhibiting the generation of silver sulfide from unreacted Ag salt, the cooling step may include a period in which the temperature lowering rate is 50°C/min or higher. The temperature lowering rate may be 50°C/min or higher particularly at the time when the temperature starts to decrease after the operation for lowering the temperature is carried out.

The atmosphere of the cooling step is preferably an inert gas atmosphere, particularly an argon atmosphere or a nitrogen atmosphere. By using an inert gas atmosphere, the generation of an oxide as a by-product as well as the oxidation of the surfaces of the resulting first semiconductor nanoparticles may be reduced or prevented.

The method of producing semiconductor nanoparticles may also include the separation step of separating the first semiconductor nanoparticles from the dispersion, and may further include the purification step as required. In the separation step, for example, the dispersion containing the first semiconductor nanoparticles may be centrifuged to recover the resulting supernatant containing the first semiconductor nanoparticles. In the purification step, for example, an appropriate organic solvent such as an alcohol may be added to the supernatant obtained in the separation step, and the resultant may be subsequently centrifuged to recover the first semiconductor nanoparticles as a precipitate. The first semiconductor nanoparticles may also be recovered by vaporizing the organic solvent from the supernatant. The thus recovered precipitate may be dried by, for example, vacuum degassing, air drying, or a combination of vacuum degassing and air drying. The air drying may be performed by, for example, leaving the precipitate in the atmosphere at normal temperature and normal pressure and, in this case, the precipitate may be left to stand for 20 hours or longer, for example, about 30 hours. Further, the recovered precipitate may be dispersed in an appropriate organic solvent.

In the method of producing semiconductor nanoparticles, the purification step that includes addition of an organic solvent such as an alcohol and centrifugation may be performed multiple times as required. As the alcohol used for purification, a lower alcohol having 1 to 4 carbon atoms, such as methanol, ethanol, or n-propyl alcohol may be used. When the precipitate is dispersed in an organic solvent, for example, a halogen-based solvent such as chloroform, dichloromethane, dichloroethane, trichloroethane, or tetrachloroethane, or a hydrocarbon-based solvent such as toluene, cyclohexane, hexane, pentane, or octane may be used as the organic solvent. From the viewpoint of internal quantum yield, the organic solvent used for dispersing the precipitate may be a halogen-based solvent.

The first semiconductor nanoparticles obtained in the above-described manner may be in the state of a dispersion or a dry powder. The first semiconductor nanoparticles may exhibit band-edge emission with a high purity. The semiconductor nanoparticles obtained by the method of producing semiconductor nanoparticles may be the first semiconductor nanoparticles, or may be second semiconductor nanoparticles obtained after the below-described second step.

The method of producing semiconductor nanoparticles may further include the second step of performing a second heat treatment of a second mixture, which contains the first semiconductor nanoparticles and a gallium halide, to obtain second semiconductor nanoparticles.

Second Step

The second step may include: a second mixing step of obtaining a second mixture that contains the first semiconductor nanoparticles obtained in the above-described first step and a gallium halide; and a second heat treatment step of performing a second heat treatment of the thus obtained second mixture to obtain second semiconductor nanoparticles.

By performing the second heat treatment of the second mixture that contains the first semiconductor nanoparticles and a gallium halide, second semiconductor nanoparticles of which the band-edge emission purity and the internal quantum yield are further improved may be produced. The reasons for this are believed, for example, as follows.

It may be thought that the Ga moiety of the gallium halide reacts with Ga defects (e.g., Ga-deficient parts) of the semiconductor containing Ga and S (e.g., $GaS_x$; x is, for example, 0.8 to 1.5), which exists on the surfaces of the first semiconductor nanoparticles, to fill the Ga defects, and further reacts with S atoms existing in the reaction system, whereby the concentration of Ga and S in the vicinity of the Ga defects is increased and the Ga defects are compensated, as a result of which the band-edge emission purity and the internal quantum yield are improved. It may also be thought that the Ga atom of the gallium halide is coordinated to the S atoms on the surface of the semiconductor containing Ga and S which exists on the surfaces of the first semiconductor nanoparticles, and the halogen atom of the thus coordinated gallium halide reacts with S components existing in the reaction system, whereby the concentration of Ga and S in the vicinity of the surfaces is increased and the remaining surface defects are reduced, as a result of which the band-edge emission purity and the internal quantum yield are improved. Further, it may be thought that, when a compound having a Ga-S bond (e.g., gallium ethyl xanthate: $Ga(EX)_3$) is used as a raw material of the first semiconductor nanoparticles, xanthic acid partially remains in the resulting first semiconductor nanoparticles, and the gallium halide acts on the partially remaining xanthic acid to facilitate conversion into $GaS_x$, whereby the concentration of Ga and S in the vicinity of the surfaces is increased and the remaining surface defects are reduced, as a result of which the band-edge emission purity and the internal quantum yield are improved.

In the second mixing step, a second mixture is obtained by mixing the first semiconductor nanoparticles and a gallium halide. The second mixture may further contain an organic solvent. Examples of the organic solvent contained in the second mixture are the same as or similar to those exemplified above for the first step. When the second mixture contains an organic solvent, the second mixture may be prepared such that the concentration of the first semiconductor nanoparticles therein is, for example, $5.0 \times 10^{-7}$ mol/L or more and $5.0 \times 10^{-5}$ mol/L or less, particularly $1.0 \times 10^{-6}$ mol/L or more and $1.0 \times 10^{-5}$ mol/L or less. It is noted here that the concentration of the first semiconductor nanoparticles is set based on the amount of substance as particles. The "amount of substance as particles" refers to a molar amount assuming a single particle as a huge molecule, and is equal to a value obtained by dividing the number of the nanoparticles contained in a dispersion by Avogadro constant (NA = $6.022 \times 10^{23}$).

Examples of the gallium halide in the second mixture include gallium fluoride, gallium chloride, gallium bromide, and gallium iodide, and the second mixture may contain at least one selected from the group consisting of these gallium halides. Further, the gallium halide may contain at least gallium chloride. These gallium halides may be used singly, or in combination of two or more thereof.

In the second mixture, a content molar ratio of the gallium halide with respect to the amount of substance as particles of the first semiconductor nanoparticles may be, for example, 0.01 or more and 50 or less, and it is preferably 0.1 or more and 10 or less.

In the second heat treatment step, a second heat treatment of the second mixture is performed to obtain second semiconductor nanoparticles. The temperature of the second heat treatment may be, for example, 200°C or higher and 320°C or lower. The second heat treatment step may include: the temperature raising step of raising the temperature of the second mixture to a temperature in a range of 200°C or higher and 320°C or lower; and the modification step of performing a heat treatment of the second mixture at a temperature in a range of 200°C or higher and 320°C or lower for a predetermined time.

The second heat treatment step may further include, prior to the temperature raising step, the pre-heat treatment step of performing a heat treatment of the second mixture at a temperature of 60°C or higher and 100°C or lower. The temperature of the heat treatment in the pre-heat treatment step may be, for example, 70°C or higher and 90°C or lower. The duration of the heat treatment in the pre-heat treatment step may be, for example, 1 minute or more and 30 minutes or less, preferably 5 minutes or more and 20 minutes or less.

The range to which the temperature is raised in the temperature raising step of the second heat treatment step may be 200°C or higher and 320°C or lower, preferably 230°C or higher and 290°C or lower. A temperature increase rate may be adjusted such that the highest temperature during the temperature raising does not exceed the intended temperature, and it is, for example, 1°C/min or higher and 50°C/min or lower.

The temperature of the heat treatment in the modification step of the second heat treatment step may be 200°C or higher and 320°C or lower, preferably 230°C or higher and 290°C or lower. The duration of the heat treatment in the modification step may be, for example, 3 seconds or longer, preferably 1 minute or longer, 10 minutes or longer, 30 minutes or longer, 60 minutes or longer, or 90 minutes or longer. Further, the duration of the heat treatment may be, for example, 300 minutes or shorter, preferably 180 minutes or shorter, or 150 minutes or shorter. The duration of the heat treatment in the modification step is defined that it starts at the time when the temperature reaches a temperature set in the above-described range (e.g., at the time when the temperature reaches 250°C in a case where the set temperature is 250°C), and ends at the time when an operation for lowering the temperature is carried out.

The atmosphere of the second heat treatment step is preferably an inert gas atmosphere, particularly an argon atmosphere or a nitrogen atmosphere. By using an inert gas atmosphere, the generation of an oxide as a by-product as well as the oxidation of the surfaces of the resulting second semiconductor nanoparticles may be reduced or prevented.

The method of producing semiconductor nanoparticles may further include, after the above-described modification step, the cooling step of lowering the temperature of a dispersion containing the resulting second semiconductor nanoparticles. The cooling step starts at the time when an operation for lowering the temperature is carried out, and ends at the time when the dispersion is cooled to 50°C or lower.

The cooling step may include a period in which the temperature lowering rate is 50°C/min or higher. The temperature lowering rate may be 50°C/min or higher particularly at the time when the temperature starts to decrease after the operation for lowering the temperature is carried out.

The atmosphere of the cooling step is preferably an inert gas atmosphere, particularly an argon atmosphere or a nitrogen atmosphere. By using an inert gas atmosphere, the generation of an oxide as a by-product as well as the oxidation of the surfaces of the resulting second semiconductor nanoparticles may be reduced or prevented.

The method of producing semiconductor nanoparticles may also include a separation step of separating the second semiconductor nanoparticles from the dispersion, and may further include a purification step as required. The separation step and the purification step are as described above in relation to the first semiconductor nanoparticles; therefore, detailed description thereof is omitted here.

The method of producing semiconductor nanoparticles may further include a surface modification step. The surface modification step may include bringing the resulting second semiconductor nanoparticles into contact with a surface modifier.

In the surface modification step, the second semiconductor nanoparticles may be brought into contact with the surface modifier by, for example, mixing the second semiconductor nanoparticles and the surface modifier. In the surface modification step, a ratio of the amount of the surface modifier with respect to the second semiconductor nanoparticles may be, for example, $1 \times 10^{-8}$ moles or more, and it is preferably $2 \times 10^{-8}$ moles or more and $5 \times 10^{-8}$ moles or less, with respect to $1 \times 10^{-8}$ moles of the second semiconductor nanoparticles. The temperature of the contact may be, for example, 0°C or higher and 300°C or lower, and it is preferably 10°C or higher and 300°C or lower. The duration of the contact may be, for example, 10 seconds or more and 10 days or less, and it is preferably 1 minute or more and 1 day or less. The atmosphere of the contact may be an inert gas atmosphere, and it is particularly preferably an argon atmosphere or a nitrogen atmosphere.

Specific examples of the surface modifier used in the surface modification step include an amino alcohol having 2 to 20 carbon atoms, an ionic surface modifier, a nonionic surface modifier, a nitrogen-containing compound containing a hydrocarbon group having 4 to 20 carbon atoms, a sulfur-containing compound containing a hydrocarbon group having 4 to 20 carbon atoms, an oxygen-containing compound containing a hydrocarbon group having 4 to 20 carbon atoms, a phosphorus-containing compound containing a hydrocarbon group having 4 to 20 carbon atoms, and a halide of a Group 2, 12, or 13 element. These surface modifiers may be used singly, or in combination of two or more different kinds thereof.

The amino alcohol used as the surface modifier may be any compound as long as it has an amino group and an alcoholic hydroxyl group and contains a hydrocarbon group having 2 to 20 carbon atoms. The number of carbon atoms in the amino alcohol is preferably 10 or less, more preferably 6 or less. The hydrocarbon group constituting the amino alcohol may be derived from a hydrocarbon such as a linear, branched, or cyclic alkane, alkene, or alkyne. The expression "derived from a hydrocarbon" used herein means that the hydrocarbon group is formed by removing at least two hydrogen atoms from the hydrocarbon. Specific examples of the amino alcohol include amino ethanol, amino propanol, amino butanol, amino pentanol, amino hexanol, and amino octanol. The amino group of the amino alcohol binds to the surface of the semiconductor nanoparticle and the hydroxyl group is exposed on the particle outermost surface on a side opposite to the surface of the semiconductor nanoparticle, as a result of which the polarity of the semiconductor nanoparticle is changed, and the dispersibility in alcohol-based solvents (e.g., methanol, ethanol, propanol, and butanol) is improved.

Examples of the ionic surface modifier used as the surface modifier include nitrogen-containing compounds, sulfur-containing compounds, and oxygen-containing compounds, which contain an ionic functional group in the individual molecules. The ionic functional group may be either cationic or anionic, and the ionic surface modifier preferably contains at least a cationic group. With regard to specific examples of the surface modifier and a surface modification method, reference may be made to, for example, Chemistry Letters, Vol. 45, pp 898-900, 2016.

The ionic surface modifier may be, for example, a sulfur-containing compound containing a tertiary or quaternary alkylamino group. The number of carbon atoms of the alkyl group in the alkylamino group may be, for example, 1 to 4. The sulfur-containing compound may also be an alkyl or alkenylthiol having 2 to 20 carbon atoms. Specific examples of the ionic surface modifier include hydrogen halides of dimethylaminoethanethiol, halogen salts of trimethylammonium ethanethiol, hydrogen halides of dimethylaminobutanethiol, and halogen salts of trimethylammonium butanethiol.

Examples of the nonionic surface modifier used as the surface modifier include nitrogen-containing compounds, sulfur-containing compounds, and oxygen-containing compounds, which have a nonionic functional group containing an alkylene glycol unit, an alkylene glycol monoalkyl ether unit, or the like. The number of carbon atoms of the alkylene group in the alkylene glycol unit may be, for example, 2 to 8, and it is preferably 2 to 4. Further, the number of repeating alkylene glycol units may be, for example, 1 to 20, and it is preferably 2 to 10. The nitrogen-containing compounds, the sulfur-containing compounds, and the oxygen-containing compounds, which constitute the nonionic surface modifier, may contain an amino group, a thiol group, and a hydroxy group, respectively. Specific examples of the nonionic surface modifier include methoxytriethyleneoxy ethanethiol and methoxyhexaethyleneoxy ethanethiol.

Examples of the nitrogen-containing compound containing a hydrocarbon group having 4 to 20 carbon atoms include amines and amides. Examples of the sulfur-containing compound containing a hydrocarbon group having 4 to 20 carbon atoms include thiols. Examples of the oxygen-containing compound containing a hydrocarbon group having 4 to 20 carbon atoms include carboxylic acids, alcohols, ethers, aldehydes, and ketones. Examples of the phosphorus-containing compound containing a hydrocarbon group having 4 to 20 carbon atoms include trialkyl phosphines, triaryl phosphines, trialkyl phosphine oxides, and triaryl phosphine oxides.

Examples of the halide of a Group 2, 12, or 13 element include magnesium chloride, calcium chloride, zinc chloride, cadmium chloride, aluminum chloride, and gallium chloride.

Semiconductor Nanoparticles

The semiconductor nanoparticles may include a first semiconductor containing silver (Ag), indium (In), gallium (Ga), and sulfur (S), and may include a second semiconductor containing Ga and S disposed on the a surface of the first semiconductor. The semiconductor nanoparticles exhibit band-edge emission with an emission peak wavelength in a wavelength range of 475 nm to 560 nm when irradiated with light having a wavelength of 365 nm, the band-edge emission purity may be 70% or higher, and the internal quantum yield of the band-edge emission may be 15% or more. In an energy dispersive X-ray analysis of the semiconductor nanoparticles, the intensity of a characteristic X-ray originating from Ga of the second semiconductor may be higher than the intensity of a characteristic X-ray originating from Ga of the first semiconductor.

The semiconductor nanoparticles, when irradiated with light having a wavelength of 365 nm, exhibit band-edge emission having an emission peak wavelength in a wavelength range of 475 nm to 560 nm, together with a high band-edge emission purity and a high internal quantum yield of the band-edge emission. This is believed to be because, for example, the crystal structure of the first semiconductor existing in the central parts of the semiconductor nanoparticles is substantially tetragonal (chalcopyrite structure), and the second semiconductor disposed on the surfaces of the semiconductor nanoparticles has a crystal structure with few Ga defects (e.g., Ga-deficient parts). The second semiconductor may be a semiconductor having a higher Ga composition ratio than the first semiconductor, a semiconductor having a lower Ag composition ratio than the first semiconductor, or a semiconductor substantially composed of Ga and S. Further, in the semiconductor nanoparticle, a deposit containing the second semiconductor may be disposed on the surface of particle containing the first semiconductor, and the particle containing the first semiconductor may be covered with the deposit containing the second semiconductor. Moreover, the semiconductor nanoparticles may have a core-shell structure in which, for example, a particle containing the first semiconductor constitutes a core and a deposit containing the second semiconductor is disposed as a shell on the surface of the core.

The first semiconductor constituting the semiconductor nanoparticles contains Ag, In, Ga, and S. Generally, a semiconductor that contains Ag, In, and S, and has a tetragonal, hexagonal, or orthorhombic crystal structure is introduced in literature and the like as a semiconductor represented by a composition formula $AgInS_2$. However, such a semiconductor does not actually have a stoichiometric composition represented by the above-described general formula and, particularly, the ratio (Ag/In + Ga) of the number of Ag atoms with respect to the number of In and Ga atoms may be lower than 1, or conversely, higher than 1. In addition, a sum of the number of Ag atoms and the number of In and Ga atoms is not always equal to the number of S atoms. Therefore, in the present specification, where it is irrelevant whether a semiconductor containing specific elements has a stoichiometric composition or not, the composition of the semiconductor is represented by a formula in which the constituent elements are connected by "-" as in Ag-In-Ga-S. Accordingly, the semiconductor nanoparticles according to the present embodiment may be considered to have a semiconductor composition of, for example, Ag-In-S, or Ag-In-Ga-S or Ag-Ga-S where In that is a Group 13 element is partially or entirely Ga that is also a Group 13 element.

Of the first semiconductor containing the above-described elements, a semiconductor having a hexagonal crystal structure is a wurtzite-type semiconductor, and a semiconductor having a tetragonal crystal structure is a chalcopyrite-type semiconductor. The crystal structure is identified by, for example, measuring the X-ray diffraction (XRD) pattern obtained by XRD analysis. Specifically, an XRD pattern obtained from the first semiconductor is compared with known XRD patterns of semiconductor nanoparticles represented by a composition $AgInS_2$, or with XRD patterns determined by simulation using crystal structure parameters. If the pattern of the first semiconductor corresponds to any of the known patterns and simulated patterns, the crystal structure of the semiconductor nanoparticles according to the present embodiment is said to be that of the corresponding known or simulated pattern.

An aggregate of the semiconductor nanoparticles may contain a mixture of semiconductor nanoparticles that contain first semiconductors having different crystal structures. In this case, peaks derived from the plural kinds of crystal structures are observed in the XRD pattern. In the semiconductor nanoparticles of an embodiment, the first semiconductor may be substantially composed of tetragonal crystals, and a peak corresponding to the tetragonal crystals is observed, while substantially no peak derived from other crystal structure may be observed.

In the composition of the first semiconductor, a total content ratio of Ag may be, for example, 10% by mole or higher and 30% by mole or lower, and it is preferably 15% by mole or higher and 25% by mole or lower. In the composition of the first semiconductor, a total content ratio of In and Ga may be, for example, 15% by mole or higher and 35% by mole or lower, and it is preferably 20% by mole or higher and 30% by mole or lower. In the composition of the first semiconductor, a total content ratio of S may be, for example, 35% by mole or higher and 55% by mole or lower, and it is preferably 40% by mole or higher and 55% by mole or lower.

The first semiconductor contains at least Ag that may be partially substituted such that the first semiconductor further contains a Group 1 or Group 11 element, which is at least one of Cu, Au, or an alkali metal, and the Group 1 or Group 11 element contained in the first semiconductor may be substantially composed of Ag. The term "substantially" used herein indicates that a ratio of the number of atoms of elements other than Ag is, for example, 10% or lower, preferably 5% or lower, more preferably 1% or lower, with respect to a total number of atoms of Ag and the Group 1 or Group 11 element other than Ag. Further, the first semiconductor may substantially contain Ag and an alkali metal (hereinafter also referred to as "$M^a$") as constituent elements. The term "substantially" used herein indicates that a ratio of the number of atoms of the Group 1 or Group 11 element other than Ag and the alkali metal is, for example, 10% or lower, preferably 5% or lower, more preferably 1% or lower, with respect to a total number of atoms of Ag, the alkali metal, and the Group 1 or Group 11 element other than Ag and the alkali metal. Examples of the alkali metal include lithium (Li), sodium (Na), potassium (K), rubidium (Rb), and cesium (Cs). The alkali metal may be a monovalent cation in the same manner as Ag and, therefore, may partially substitute Ag in the composition of the first semiconductor. Particularly, Li is preferably used because it has substantially the same ionic radius as Ag. Partial substitution of Ag in the composition of the first semiconductor leads to, for example, a widened band gap and a shift of the emission peak wavelength to the shorter wavelength side. In addition, it is believed that, although the details are unclear, the lattice defects of the first semiconductor are reduced and the internal quantum yield of band-edge emission is improved. When the first semiconductor contains an alkali metal, the first semiconductor may contain at least Li.

When the first semiconductor contains Ag and an alkali metal ($M^a$), a content ratio of the alkali metal in the composition of the first semiconductor is, for example, higher than 0% by mole and lower than 30% by mole, preferably 1% by mole or higher and 25% by mole or lower. Further, in the composition of the first semiconductor, a ratio ($M^a/(Ag + M^a)$) of the number of alkali metal ($M^a$) atoms with respect to a total of the number of Ag atoms and the number of alkali metal ($M^a$) atoms is, for example, lower than 1, preferably 0.8 or lower, more preferably 0.4 or lower, still more preferably 0.2 or lower. This ratio is, for example, higher than 0, preferably 0.05 or higher, more preferably 0.1 or higher.

The first semiconductor contains In and Ga that may be partially substituted such that the first semiconductor further contains at least one Group 13 element of Al or Tl, and the Group 13 element contained in the first semiconductor may be substantially composed of In and Ga. The term "substantially" used herein indicates that a ratio of the number of atoms of the Group 13 element other than In and Ga is, for example, 10% or lower, preferably 5% or lower, more preferably 1% or lower, with respect to a total number of atoms of In, Ga, and the Group 13 element other than In and Ga.

In the first semiconductor, a ratio (In/(In + Ga)) of the number of In atoms with respect to a total number of In and Ga atoms may be, for example, 0.01 or higher and lower than 1, and it is preferably 0.1 or higher and 0.99 or lower. When the ratio of the number of In atoms with respect to a total number of In and Ga atoms is in this predetermined range, a short emission peak wavelength (e.g., 545 nm or shorter) may be obtained. Further, a ratio (Ag/(In + Ga)) of the number of Ag atoms with respect to a total number of In and Ga atoms is, for example, 0.3 or higher and 1.2 or lower, preferably 0.5 or higher and 1.1 or lower. A ratio (S/(Ag + In + Ga)) of the number of S atoms with respect to a total number of atoms of Ag, In, and Ga is, for example, 0.8 or higher and 1.5 or lower, preferably 0.9 or higher and 1.2 or lower.

The first semiconductor contains S that may be partially substituted such that the first semiconductor further contains at least one Group 16 element of Se or Te, and the Group 16 element contained in the first semiconductor may be substantially composed of S. The term "substantially" used herein indicates that a ratio of the number of atoms of the Group 16 element other than S is, for example, 10% or lower, preferably 5% or lower, more preferably 1% or lower, with respect to a total number of atoms S and the Group 16 element other than S.

The first semiconductor may be substantially composed of Ag, In, Ga, S, and the above-described elements partially substituting these elements. The term "substantially" used herein takes into consideration that elements other than Ag, In, Ga, S, and the elements partially substituting these elements may be unavoidably incorporated due to, for example, contamination with impurities.

The first semiconductor may have a composition represented by, for example, the following formula (1):

$$(Ag_p M^a{}_{(1-p)})_q In_x Ga_{(1-r)} S_{(q+3)/2} \quad (1)$$

wherein, p, q, and r satisfy $0 < p \leq 1$, $0.20 < q \leq 1.2$, and $0 < r < 1$; and $M^a$ represents an alkali metal.

A second semiconductor may be disposed on the surfaces of the semiconductor nanoparticles. The second semiconductor may contain a semiconductor having a larger band-gap energy than that of the first semiconductor. The composition of the second semiconductor may have a higher Ga molar content than the composition of the first semiconductor. A ratio of the Ga molar content in the composition of the second semiconductor with respect to the Ga molar content in the composition of the first semiconductor may be, for example, higher than 1 and 5 or lower, preferably 1.1 or higher and 3 or lower.

Further, the composition of the second semiconductor may have a lower Ag molar content than the composition of the first semiconductor. A ratio of the Ag molar content in the composition of the second semiconductor with respect to the Ag molar content in the composition of the first semiconductor may be, for example, 0.1 to 0.7, preferably 0.2 or higher but 0.5 or lower. The ratio of the Ag molar content in the composition of the second semiconductor may be, for example, 0.5 or lower, preferably 0.2 or lower, 0.1 or lower, or substantially 0. The term "substantially" used herein indicates that, when a total number of atoms of all elements contained in the second semiconductor is taken as 100%, a ratio of the number of Ag atoms is, for example, 10% or lower, preferably 5% or lower, more preferably 1% or lower.

In the semiconductor nanoparticles, the second semiconductor disposed on the surface may contain a semiconductor containing Ga and S. This semiconductor containing Ga and S may be a semiconductor having a larger band-gap energy than that of the first semiconductor.

In the composition of the semiconductor containing Ga and S that is contained in the second semiconductor, Ga may be partially substituted with at least one Group 13 element selected from the group consisting of boron (B), aluminum (Al), indium (In), and thallium (Tl). Further, S may be partially substituted with at least one Group 16 element selected from the group consisting of oxygen (O), selenium (Se), tellurium (Te), and polonium (Po).

The semiconductor containing Ga and S may be a semiconductor substantially composed of Ga and S. The term "substantially" used herein indicates that, when a total number of atoms of all elements contained in the semiconductor containing Ga and S is taken as 100%, a ratio of the number of atoms of elements other than Ga and S is, for example, 10% or lower, preferably 5% or lower, more preferably 1% or lower.

The semiconductor containing Ga and S may be formed by selecting its composition and the like in accordance with the band-gap energy of the above-described first semiconductor. Alternatively, when the composition and the like of the semiconductor containing Ga and S are predetermined, the first semiconductor may be designed such that the band-gap energy of the first semiconductor is smaller than that of the semiconductor containing Ga and S. Generally, a semiconductor composed of Ag-In-S has a band-gap energy of 1.8 eV or higher and 1.9 eV or lower.

Specifically, the semiconductor containing Ga and S may have a band-gap energy of, for example, 2.0 eV or higher and 5.0 eV or lower, particularly 2.5 eV or higher and 5.0 eV or lower. The band-gap energy of the semiconductor containing Ga and S may be larger than that of the first semiconductor by, for example, about 0.1 eV or higher and 3.0 eV or lower, particularly about 0.3 eV or higher and 3.0 eV or lower, more particularly about 0.5 eV or higher and 1.0 eV or lower. When the difference between the band-gap energy of the semiconductor containing Ga and S and the band-gap energy of the first semiconductor is equal to or greater than the above-described lower limit value, the ratio of emission other than band-edge emission in the emission from the semiconductor nanoparticles tends to be reduced, resulting in an increase in the ratio of band-edge emission.

The second semiconductor may contain an oxygen (O) atom. An oxygen atom-containing semiconductor tends to have a larger band-gap energy than the above-described first semiconductor. The form of an oxygen atom-containing semiconductor in the second semiconductor is not clear; however, it may be, for example, Ga-O-S or $Ga_2O_3$.

The second semiconductor may further contain an alkali metal ($M^a$) in addition to Ga and S. The alkali metal contained in the second semiconductor may include at least lithium. When the second semiconductor contains an alkali metal, a ratio of the number of alkali metal atoms with respect to a sum of the number of alkali metal atoms and the number of Ga atoms may be, for example, 0.01 or higher and lower than 1, or 0.1 or higher and 0.9 or lower. Further, a ratio of the number of S atoms with respect to a sum of the number of alkali metal atoms and the number of Ga atoms may be, for example, 0.25 or higher and 0.75 or lower.

The second semiconductor may have a crystal system conforming to that of the first semiconductor, and may have a lattice constant that is the same as or close to that of the first semiconductor. The second semiconductor which has a crystal system conforming to that of the first semiconductor and a lattice constant close to that of the first semiconductor (including a case where a multiple of the lattice constant of the second semiconductor is similar to the lattice constant of the first semiconductor) may favorably cover the periphery of the first semiconductor. For example, the first semiconductor generally has a tetragonal crystal system, and examples of a crystal system conforming thereto include a tetragonal system and an orthorhombic crystal system. When Ag-In-S has a tetragonal crystal system, it is preferred that the lattice constants of its constituent elements be 0.5828 nm, 0.5828 nm, and 1.119 nm, respectively; and that the second semiconductor covering this Ag-In-S has a tetragonal or orthorhombic crystal system, and its lattice constants or multiple thereof be close to the lattice constants of Ag-In-S. Alternatively, the second semiconductor may be amorphous.

Whether the second semiconductor is amorphous or not may be confirmed by observing the semiconductor nanoparticles by HAADF-STEM. When the second semiconductor is amorphous, specifically, in HAADF-STEM, a central part is observed with a regular pattern, such as a stripe pattern or a dot pattern, and its surrounding part is observed with no regular pattern. According to HAADF-STEM, a substance having a regular structure as in the case of a crystalline substance is observed as an image having a regular pattern, while a substance having no regular structure as in the case of an amorphous substance is not observed as an image having a regular pattern. Therefore, when the second semiconductor is amorphous, the second semiconductor may be observed as a part that is clearly different from the first semiconductor observed as an image having a regular pattern (the first semiconductor may have a crystal structure of a tetragonal system or the like).

When the second semiconductor is formed of Ga-S, because Ga is an element lighter than Ag and In that are contained in the first semiconductor, the second semiconductor tends to be observed darker than the first semiconductor in an image obtained by HAADF-STEM.

Whether the second semiconductor is amorphous or not may also be confirmed by observing the semiconductor nanoparticles of the present embodiment under a high-resolution transmission electron microscope (HRTEM). In an image obtained by HRTEM, the first semiconductor portion is observed as a crystal lattice image (an image having a regular pattern) while the second semiconductor portion that is amorphous is not observed as a crystal lattice image, and the second semiconductor portion is observed as a part having a black and white contrast but no regular pattern.

Meanwhile, the second semiconductor preferably does not form a solid solution with the first semiconductor. If the second semiconductor forms a solid solution with the first semiconductor, because the second semiconductor and the first semiconductor are integrated together, the mechanism of the present embodiment in which the second semiconductor is disposed on the surfaces of the semiconductor nanoparticles and the band-edge emission is thereby obtained cannot be attained. For example, it has been confirmed that band-edge emission cannot be obtained from the semiconductor nanoparticles even when zinc sulfide (Zn-S) having a stoichiometric or non-stoichiometric composition is disposed on the surfaces of the semiconductor nanoparticles containing the first semiconductor composed of Ag-In-S. Zn-S, in its relationship with Ag-In-S, satisfies the above-described conditions in terms of band-gap energy, and gives a type-I band alignment. Nevertheless, band-edge emission was not obtained from the above-described specific semiconductor, and it is surmised that the reason for this is because the first semiconductor and Zn-S formed a solid solution.

The semiconductor nanoparticles may have an average particle size of, for example, 50 nm or smaller. From the standpoints of the ease of production and the internal quantum yield of band-edge emission, the average particle size is preferably in a range of 1 nm or larger and 20 nm or smaller, more preferably 1.6 nm or larger and 8 nm or smaller, particularly preferably 2 nm or larger and 7.5 nm or smaller.

The average particle size of the semiconductor nanoparticles may be determined from, for example, a TEM image captured using a transmission electron microscope (TEM). The particle size of individual particle specifically refers to the length of the longest line segment among those line segments that exist inside the particle observed in a TEM image and connect two arbitrary points on the perimeter of the particle.

However, for a rod-shaped particle, the length of its short axis is regarded as the particle size. The term "rod-shaped particle" used herein refers to a particle observed in a TEM image to have a short axis and a long axis perpendicular to the short axis, in which a ratio of the length of the long axis with respect to the length of the short axis is higher than 1.2. In a TEM image, a rod-shaped particle is observed to have, for example, a quadrangular shape such as a rectangular shape, an elliptical shape, or a polygonal shape. The shape of a cross-section that is a plane perpendicular to the long axis of the rod shape may be, for example, circular, elliptical, or polygonal. Specifically, for a rod-shaped particle having an elliptical shape, the length of the long axis means the length of the longest line segment among those line segments connecting any two points on the perimeter of the particle and, for a rod-shaped particle having a rectangular or polygonal shape, the length of the long axis means the length of the longest line segment among those line segments that are parallel to the longest side among all sides defining the perimeter of the particle and connect any two points on the perimeter of the particle. The length of the short axis means the length of the longest line segment that is perpendicular to the line segment defining the length of the long axis, among those line segments connecting any two points on the perimeter of the particle.

The average particle size of the semiconductor nanoparticles is determined by measuring the particle size for all measurable particles observed in a TEM image captured at a magnification of ×50,000 to ×150,000, and calculating the arithmetic mean of the thus measured values. The "measurable" particles are those particles whose outlines are entirely observable in a TEM image. Accordingly, in a TEM image, a particle whose outline is partially not included in the captured area and thus a part of which particle appears to be "cut off" is not a measurable particle. When a single TEM image contains 100 or more measurable particles, the average particle size is determined using this TEM image. Meanwhile, when a single TEM image contains less than 100 measurable particles, another TEM image is further captured at a different position, and the particle size is measured for 100 or more measurable particles contained in two or more TEM images to determine the average particle size.

In the semiconductor nanoparticles, the parts composed of the first semiconductor may be in a particulate form and have an average particle size of, for example, 10 nm or smaller, particularly 8 nm or smaller, or smaller than 7.5 nm. The average particle size of the first semiconductor may be in a range of 1.5 nm or larger and 10 nm or smaller, preferably in a range of 1.5 nm or larger but smaller than 8 nm, or 1.5 nm or larger but smaller than 7.5 nm. When the average particle size of the first semiconductor is equal to or smaller than the above-described upper limit value, a quantum size effect is likely to be obtained.

In the semiconductor nanoparticles, the parts composed of the second semiconductor may have a thickness in a range of 0.1 nm or larger and 50 nm or smaller, or 0.1 nm or larger and 10 nm or smaller, particularly in a range of 0.3 nm or larger and 3 nm or smaller. When the thickness of the second semiconductor is equal to or larger than the above-described lower limit value, the effect provided by disposing the second semiconductor in the semiconductor nanoparticles is sufficiently exerted, so that band-edge emission is likely to be obtained.

The average particle size of the first semiconductor and the thickness of the second semiconductor may be determined by, for example, observing the semiconductor nanoparticles by HAADF-STEM. Particularly, when the second semiconductor is amorphous, the thickness of the second semiconductor part easily observable by HAADF-STEM as a part different from the first semiconductor may be easily determined. In this case, the particle size of the first semiconductor may be determined in accordance with the method described above for semiconductor nanoparticles. When the thickness of the second semiconductor is not uniform, the smallest thickness is defined as the thickness of the second semiconductor in the semiconductor nanoparticles.

The semiconductor nanoparticles preferably have a substantially tetragonal crystal structure. The crystal structure.is identified by, for example, measuring the X-ray diffraction (XRD) pattern obtained by XRD analysis in the same manner as described above. The term "substantially tetragonal crystal" used herein indicates that a ratio of the height of a peak at about 48°, which represents hexagonal and orthorhombic crystals, with respect to the height of a main peak at about 26°, which represents a tetragonal crystal, is, for example, 10% or less, or 5% or less.

The semiconductor nanoparticles, when irradiated with light having a wavelength of 365 nm, may exhibit band-edge emission having an emission peak wavelength in a wavelength range of 475 nm or more and 560 nm or less, and the range of the emission peak wavelength may be preferably 510 nm or more and 550 nm or less, more preferably 515 nm or more and 545 nm or less. Further, in the emission spectrum of the semiconductor nanoparticles, the full width at half maximum may be, for example, 45 nm or less, preferably 40 nm or less, or 35 nm or less. A lower limit of the full width at half maximum may be, for example, 15 nm or more. Moreover, the emission lifetime of a main component (band-edge emission) is preferably 200 ns or shorter.

The term "emission lifetime" used herein refers to a lifetime of emission that is measured using a device called fluorescence lifetime measuring device. Specifically, the above-descried "emission lifetime of the main component" may be determined by the following procedure. First, the semiconductor nanoparticles are allowed to emit light by irradiation with an excitation light, and a change in the attenuation (afterglow) over time is measured for a light having a wavelength near the spectral emission peak, for example, a wavelength within a range of the peak wavelength ±50 nm. The measurement of the change over time is initiated upon termination of the irradiation of the excitation light. The resulting attenuation curve is generally a sum of plural attenuation curves derived from relaxation processes of light emission, heat, and the like. Accordingly, in the present embodiment, assuming that the attenuation curve contains three components (i.e. three attenuation curves), parameter fitting is performed such that the attenuation curve is represented by the following formula where I(t) denotes the emission intensity. The parameter fitting is performed using a special software.

$$I(t) = A_1 \exp(-t/\tau_1) + A_2 \exp(-t/\tau_2) + A_3 \exp(-t/\tau_3)$$

In the above formula, $\tau_1$, $\tau_2$, and $\tau_3$ of the respective components each denote the time required for attenuation of the initial emission intensity to 1/e (36.8%), which corresponds to the emission lifetime of each component. The emission lifetime is in ascending order of $\tau_1$, $\tau_2$, and $\tau_3$. Further, $A_1$, $A_2$, and $A_3$ denote contribution ratios of the respective components. For example, when a component having the largest integral value of curves represented by $A_x \exp(-t/\tau_x)$ is defined as the main component, the main component has an emission lifetime $\tau$ of 200 ns or shorter. Such emission is presumed to be band-edge emission. For identification of the main component, the values of $A_x \times \tau_x$ obtained by integration of the t value of $A_x \exp(-t/\tau_x)$ from 0 to infinity are compared, and a component having the largest value is defined as the main component.

An actual attenuation curve is not much different from those attenuation curves that are each drawn from a formula obtained by performing parameter fitting where the emission attenuation curve is assumed to contain three, four, or five components. Therefore, for determination of the emission lifetime of the main component in the present embodiment, the number of components contained in the emission attenuation curve is assumed to be three so as to avoid complicated parameter fitting.

The emission of the semiconductor nanoparticles may include defect emission (e.g., donor-acceptor emission) in addition to band-edge emission; however, the emission is preferably substantially band-edge emission alone. Defect emission generally has a longer emission lifetime and a broader spectrum with a peak on the longer wavelength side as compared to band-edge emission. The expression "substantially band-edge emission alone" used herein means that the purity of the band-edge emission component in the emission spectrum (hereinafter, also referred to as "band-edge emission purity") is 40% or higher, and this purity is preferably 70% or higher, more preferably 80% or higher, still more preferably 90% or higher, particularly preferably 95% or higher. An upper limit value of the purity of the band-edge emission component may be, for example, 100% or lower, lower than 100%, or 99% or lower. The "purity of the band-edge emission component" is represented by the following formula when parameter fitting, where a band-edge emission peak and a defect emission peak are assumed to each have a shape of normal distribution, is performed for the emission spectrum to separate its peaks into two types, which are the band-edge emission peak and the defect emission peak, and the areas of these peaks are denoted as $a_1$ and $a_2$, respectively:

$$\text{Purity (\%) of band-edge emission component} = a_1/(a_1 + a_2) \times 100$$

When the emission spectrum contains no band-edge emission at all, i.e. when the emission spectrum contains only defect emission, the purity of the band-edge emission component is 0%; when the emission spectrum contains band-edge emission and defect emission that have the same peak area, the purity of the band-edge emission component is 50%; and when the emission spectrum contains only band-edge emission, the purity of the band-edge emission component is 100%.

The internal quantum yield of the band-edge emission is defined as a value obtained by multiplying the internal quantum yield, which is measured using a quantum yield measuring device at a temperature of 25°C and calculated under the conditions of an excitation light wavelength of 450 nm and a fluorescence wavelength range of 470 nm or more and 900 nm or less, an excitation light wavelength of 365 nm and a fluorescence wavelength range of 450 nm or more and 950 nm or less, or an excitation light wavelength of 450 nm and a fluorescence wavelength range of 500 nm or more and 950 nm or less, by the above-described purity of the band-edge emission component, and dividing the product by 100. The internal quantum yield of the band-edge emission of the semiconductor nanoparticles is, for example, 15% or more, preferably 50% or more, more preferably 60% or more, still more preferably 70% or more, particularly preferably 80% or more.

The peak position of the band-edge emission by the semiconductor nanoparticles may be shifted by modifying the particle size of the semiconductor nanoparticles. For example, when the particle size of the semiconductor nanoparticles is reduced, the peak wavelength of the band-edge emission tends to shift to the shorter wavelength side. A further reduction in the particle size of the semiconductor nanoparticles tends to further reduce the spectral full width at half maximum of the band-edge emission.

When the semiconductor nanoparticles exhibit defect emission in addition to band-edge emission, the intensity ratio of the band-edge emission may be, for example, 0.75 or higher, and it is preferably 0.85 or higher, more preferably 0.9 or higher, particularly preferably 0.93 or higher. An upper limit value thereof may be, for example, 1 or lower, lower than 1, or 0.99 or lower. The intensity ratio of the band-edge emission is represented by the following formula when parameter fitting, where a band-edge emission peak and a defect emission peak are assumed to each have a shape of normal distribution, is performed for the emission spectrum to separate its peaks into two types, which are the band-edge emission peak and the defect emission peak, and the maximum intensities of these peaks are denoted as $b_1$ and $b_2$, respectively:

$$\texttt{Intensity ratio of band-edge emission} = b_1/(b_1 + b_2)$$

When the emission spectrum contains no band-edge emission at all, i.e. when the emission spectrum contains only defect emission, the intensity ratio of the band-edge emission is 0; when the emission spectrum contains band-edge emission and defect emission that have the same maximum peak intensity, the intensity ratio of the band-edge emission is 0.5; and when the emission spectrum contains only band-edge emission, the intensity ratio of the band-edge emission is 1.

The semiconductor nanoparticles preferably exhibit an absorption or excitation spectrum (also referred to as "fluorescence excitation spectrum") with an exciton peak. An exciton peak is a peak resulting from exciton formation, and the appearance of this peak in an absorption or excitation spectrum means that the particles have a small particle size distribution and few crystal defects, and are thus suitable for band-edge emission. A sharper exciton peak means that an aggregate of the semiconductor nanoparticles contains a greater amount of particles having a uniform particle size with few crystal defects. Accordingly, it is expected that the semiconductor nanoparticles exhibit emission with a narrower full width at half maximum and an improved emission efficiency. In the absorption or excitation spectrum of the semiconductor nanoparticles of the present embodiment, an exciton peak is observed, for example, in a range of 400 nm or more and 550 nm or less, preferably 430 nm or more and 500 nm or less. The excitation spectrum for checking the presence or absence of an exciton peak may be measured by setting the observation wavelength around the peak wavelength.

The surfaces of the semiconductor nanoparticles may be modified with a surface modifier. Specific examples of the surface modifier include an amino alcohol having 2 to 20 carbon atoms, an ionic surface modifier, a nonionic surface modifier, a nitrogen-containing compound containing a hydrocarbon group having 4 to 20 carbon atoms, a sulfur-containing compound containing a hydrocarbon group having 4 to 20 carbon atoms, an oxygen-containing compound containing a hydrocarbon group having 4 to 20 carbon atoms, a phosphorus-containing compound containing a hydrocarbon group having 4 to 20 carbon atoms, and a halide of a Group 2, 12, or 13 element. These surface modifiers may be used singly, or in combination of two or more different kinds thereof. The details of the above-exemplified surface modifiers are as described above.

The surfaces of the semiconductor nanoparticles may be modified with a gallium halide. By modifying the surfaces of the semiconductor nanoparticles with a gallium halide, the internal quantum yield of the band-edge emission is improved. Specific examples of the gallium halide include gallium chloride, gallium fluoride, gallium bromide, and gallium iodide.

In the semiconductor nanoparticles, the surface of the second semiconductor may be modified with a gallium halide. By modifying the surface of the second semiconductor in the semiconductor nanoparticles with a gallium halide, the internal quantum yield of the band-edge emission is improved.

The emission of the semiconductor nanoparticles surface-modified with a gallium halide may include defect emission (donor-acceptor emission) in addition to band-edge emission; however, the emission is preferably substantially band-edge emission alone. The expression "substantially band-edge emission alone" used herein means that, as described for the above-described semiconductor nanoparticles, the purity of the band-edge emission component is preferably 70% or higher, more preferably 80% or higher, still more preferably 90% or higher, particularly preferably 95% or higher.

The measurement of the internal quantum yield of the band-edge emission of the semiconductor nanoparticles surface-modified with a gallium halide is as described for the above-described semiconductor nanoparticles, and the internal quantum yield of the band-edge emission is, for example, 15% or more, preferably 50% or more, more preferably 60% or more, still more preferably 70% or more, particularly preferably 80% or more.

A second semiconductor may be disposed on the surfaces of the semiconductor nanoparticles containing the first semiconductor. When the composition of the second semiconductor has a higher Ga molar content than the composition of the first semiconductor, as for intensity of a characteristic X-ray originating from Ga that is determined by an energy dispersive X-ray analysis (EDX), the second semiconductor has a higher intensity than that of the first semiconductor. The intensity of a characteristic X-ray is measured as a net count of characteristic X-rays. The phrase "the second semiconductor has a higher intensity than that of the first semiconductor" may mean that a maximum value of the intensity of the characteristic X-ray originating from Ga of the second semiconductor is greater than a minimum value of the intensity of the characteristic X-ray originating from Ga of the first semiconductor. Alternatively, the phrase may mean that an average value of the intensity of the characteristic X-ray originating from Ga of the second semiconductor is greater than an average value of the intensity of the characteristic X-ray originating from Ga of the first semiconductor.

For example, when the particle shape of the semiconductor nanoparticles is observed under a scanning transmission electron microscope (STEM) and a line analysis is performed for the composition of the semiconductor nanoparticles in the diameter direction using EDX, the intensity of the characteristic X-ray originating from Ga that is detected in a first region in the vicinity of the surfaces of the individual semiconductor nanoparticles corresponding to the second semiconductor is higher than the intensity of the characteristic X-ray originating from Ga that is detected in a second region in the vicinity of the centers of the individual semiconductor nanoparticles corresponding to the first semiconductor. The first region may be, for example, a region having a thickness of 2 nm or less, preferably 1 nm or less, in the direction from the surface to the center of individual semiconductor nanoparticle. The second region may be, for example, a region in a range of 2 nm or more and 8 nm or less, preferably 1 nm or more and 9 nm or less, in the direction from the surface to the center of individual semiconductor nanoparticle.

A ratio of the maximum value of the intensity of the characteristic X-ray originating from Ga of the second semiconductor with respect to the minimum value of the intensity of the characteristic X-ray originating from Ga of the first semiconductor may be, for example, higher than 1, preferably 1.1 or higher and 3 or lower, more preferably 1.2 or higher, or 1.5 or higher, but 2.5 or lower, or 1.6 or lower. The intensity of a characteristic X-ray originating from Ga based on EDX is measured using, for example, a multifunctional electron microscope (e.g., JEM-F200 manufactured by JEOL Ltd.) equipped with an XDS detector under the following conditions: accelerating voltage = 80 kV, resolution = 256 × 256, frame time = 5 seconds, number of frames = 500.

Light Emitting Device

The light emitting device includes: a light conversion member containing the above-described semiconductor nanoparticles; and a semiconductor light emitting element. According to this light emitting device, for example, the semiconductor nanoparticles absorb a portion of the light irradiated from the semiconductor light emitting element and emit a longer-wavelength light. Further, the light emitted from the semiconductor nanoparticles is combined with the remainder of the light emitted from the semiconductor light emitting element, and the resulting mixed light may be utilized as a light emitted from the light emitting device.

Specifically, by using a semiconductor light emitting element that emits blue-violet light or blue light having a peak wavelength of about 400 nm to 490 nm as the above-described semiconductor light emitting element and semiconductor nanoparticles that absorb blue light and emit yellow light as the above-described semiconductor nanoparticles, a light emitting device that emits white light may be obtained. A white light emitting device may also be obtained by using, as the above-described semiconductor nanoparticles, two kinds of semiconductor nanoparticles that absorb blue light and emit green light and semiconductor nanoparticles that absorb blue light and emit red light.

Alternatively, a white light emitting device may be obtained even in the case of using a semiconductor light emitting element that emits ultraviolet rays having a peak wavelength of 400 nm or shorter and three kinds of semiconductor nanoparticles that each absorb ultraviolet rays and respectively emit blue light, green light, or red light. In this case, it is desired that all of the light emitted from the light emitting element be absorbed and converted by the semiconductor nanoparticles so that the ultraviolet rays emitted from the light emitting element do not leak to the outside.

Further, a white light emitting device may be obtained by using a semiconductor light emitting element that emits blue-green light having a peak wavelength of about 490 nm to 510 nm and semiconductor nanoparticles that absorb the blue-green light and emit red light.

Moreover, it is possible to obtain a light emitting device that emits near-infrared rays by using a semiconductor light emitting element that emits visible light, for example, one which emits red light having a wavelength of 700 nm to 780 nm, as the above-described semiconductor light emitting element, and semiconductor nanoparticles that absorb visible light and emit near-infrared rays as the above-described semiconductor nanoparticles.

The semiconductor nanoparticles may be used in combination with other semiconductor quantum dots, or other phosphors that are not quantum dots (e.g., organic phosphors or inorganic phosphors). The other semiconductor quantum dots are, for example, binary semiconductor quantum dots. As the phosphors that are not quantum dots, for example, garnet-based phosphors such as aluminum-garnet phosphors may be used. Examples of the garnet-based phosphors include a cerium-activated yttrium-aluminum-garnet phosphor, and a cerium-activated lutetium-aluminum-garnet phosphor. Examples of phosphors that may be used also include: nitrogen-containing calcium aluminosilicate-based phosphors activated by europium and/or chromium; silicate-based phosphors activated by europium; nitride-based phosphors, such as $\beta$-SiAlON-based phosphors CASN-based or SCASN-based phosphors; rare earth nitride-based phosphors, such as $LnSi_3N_{11}$-based or LnSiAlON-based phosphors; oxynitride-based phosphors, such as $BaSi_2O_2N_2$:Eu-based or $Ba_3Si_6O_{12}N_2$:Eu-based phosphors; sulfide-based phosphors, such as CaS-based, $SrGa_2S_4$-based, or ZnS-based phosphors; chlorosilicate-based phosphors; $SrLiAl_3N_4$:Eu phosphor; $SrMg_3SiN_4$:Eu phosphor; and manganese-activated fluoride complex phosphors, such as a $K_2SiF_6$:Mn phosphor and a $K_2(Si,Al)$ $F_6$:Mn phosphor (e.g., $K_2Si_{0.99}Al_{0.01}F_{5.99}$:Mn) . In the present specification, plural elements listed separately with commas (,) in a formula representing the composition of a phosphor mean that at least one of the plural elements is contained in the composition. Further, in a formula representing the composition of a phosphor, the part preceding a colon (:) represents a host crystal, and the part following the colon (:) represents an activation element.

In the light emitting device, the light conversion member containing the semiconductor nanoparticles may be, for example, a sheet or a plate-like member, or may be a member having a three-dimensional shape. One example of the member having a three-dimensional shape is, in a surface-mount light-emitting diode in which a semiconductor light emitting element is disposed on the bottom surface of a recess formed in a package, an encapsulating that is formed by being supplied in the recess with a resin to encapsulate the light emitting element.

Another example of the light conversion member is, in a case where a semiconductor light emitting element is disposed on a planar substrate, a resin member that is formed in such a manner to surround the upper surface and lateral surfaces of the semiconductor light emitting element with a substantially uniform thickness. Yet another example of the light conversion member is, in a case where a reflective material-containing resin member is supplied to the surrounding of a semiconductor light emitting element such that the upper end of this resin member forms a single plane with the semiconductor light emitting element, a resin member that is formed in a plate-like shape with a predetermined thickness on top of the semiconductor light emitting element and the reflective material-containing resin member.

The light conversion member may be in contact with the semiconductor light emitting element, or may be disposed apart from the semiconductor light emitting element. Specifically, the light conversion member may be a pellet-like, sheet-like, plate-like, or rod-like member disposed apart from the semiconductor light emitting element, or a member disposed in contact with the semiconductor light emitting element, such as an encapsulating member, a coating member (a member covering the light emitting element that is disposed separately from a molded member), or a molded member (e.g., a lens-shaped member).

In the light emitting device, when two or more kinds of semiconductor nanoparticles that emit different wavelengths of light are used, the two or more kinds of semiconductor nanoparticles may be mixed within a single light conversion member, or two or more light conversion members each containing only a single kind of semiconductor nanoparticles may be used in combination. In the latter case, the two or more light conversion members may form a laminated structure, or may be disposed in a dot-like or striped pattern on a plane.

One example of the semiconductor light emitting element is an LED chip. The LED chip may include a semiconductor layer composed of one or more selected from the group consisting of GaN, GaAs, InGaN, AlInGaP, GaP, SiC, and ZnO. A semiconductor light emitting element that emits blue-violet light, blue light, or ultraviolet rays includes a semiconductor layer composed of, for example, a GaN compound having a composition represented by $In_XAl_YGa_{1-X-Y}N$ $(0 \le X, 0 \le Y, X + Y < 1)$.

The light emitting device of the present embodiment is preferably incorporated as a light source in a liquid-crystal display device. Because the band-edge emission by the semiconductor nanoparticles has a short emission lifetime, a light emitting device using the semiconductor nanoparticles is suitable as a light source of a liquid-crystal display device that requires a relatively high response speed. Further, the semiconductor nanoparticles of the present embodiment may exhibit band-edge emission having an emission peak with a small full width at half maximum. Therefore, a liquid-crystal display device having good color reproducibility may be obtained without the use of a thick color filter by configuring the light emitting device such that: blue light having a peak wavelength in a range of 420 nm to 490 nm is provided by a blue semiconductor light emitting element, while green light having a peak wavelength in a range of 510 nm to 550 nm, preferably 530 nm to 540 nm, and red light having a peak wavelength in a range of 600 nm to 680 nm, preferably 630 nm to 650 nm, are provided by the semiconductor nanoparticles; or ultraviolet light having a peak wavelength of 400 nm or shorter is provided by a semiconductor light emitting element, while blue light having a peak wavelength in a range of 430 nm to 470 nm, preferably 440 nm to 460 nm, green light having a peak wavelength in a range of 510 nm to 550 nm, preferably 530 nm to 540 nm, and red light having a peak wavelength in a range of 600 nm to 680 nm, preferably 630 nm to 650 nm, are provided by the semiconductor nanoparticles. The light emitting device may be used as, for example, a direct backlight or an edge backlight.

Alternatively, a sheet, a plate-like member, or a rod, which contains the semiconductor nanoparticles and is formed of a resin or glass, may be incorporated into a liquid-crystal display device as a light conversion member independent of the light emitting device.

EXAMPLES

The present invention will now be described more concretely by way of Examples; however, the present invention is not limited to the below-described Examples.

(Example 1)

First Step

A first mixture was obtained by mixing 0.1 mmol of silver ethyl xanthate (Ag(EX)), 0.12 mmol of indium acetate (In(OAc)$_3$), 0.2 mmol of gallium ethyl xanthate (Ga(EX)$_3$), and 0.020 mmol of gallium chloride with 20 mL of oleylamine (OLA). This first mixture was heat-treated at 260°C for 120 minutes with stirring in a nitrogen atmosphere. The thus obtained suspension was allowed to cool and then centrifuged (radius: 146 mm, at 3,800 rpm for 5 minutes), and the resulting precipitate was removed to obtain a dispersion of first semiconductor nanoparticles.

Measurement of Emission Spectrum

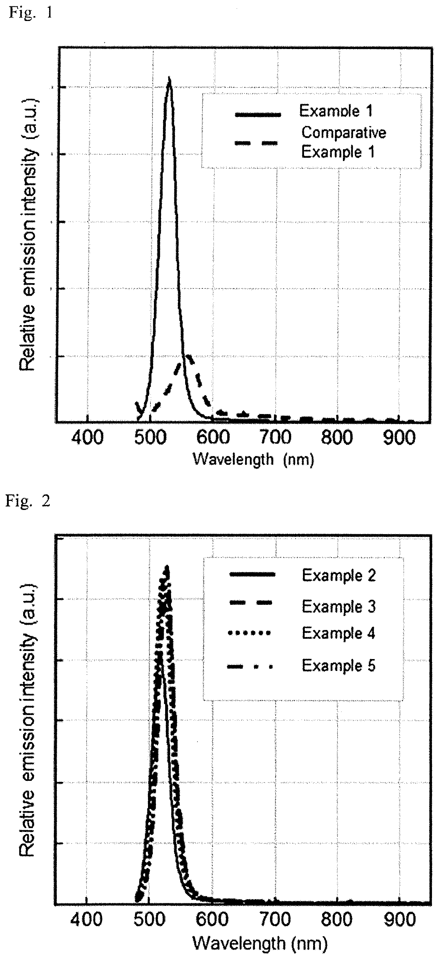

Emission spectrum of the thus obtained first semiconductor nanoparticles was measured, and the band-edge emission peak wavelength, the full width at half maximum, the band-edge emission purity, and the internal quantum yield of band-edge emission were determined. The emission spectrum was measured in a wavelength range of 300 nm to 950 nm using a quantum efficiency measurement system (trade name: QE-2100, manufactured by Otsuka Electronics Co., Ltd.) at room temperature (25°C) with an excitation light wavelength of 365 nm, and the internal quantum yield was calculated for a wavelength range of 450 nm to 950 nm. The results thereof are shown in Table 1 and FIG. 1.

(Comparative Example 1)

Synthesis of Semiconductor Nanoparticles

In a reaction vessel, 0.4 mmol of silver acetate (AgOAc), 0.16 mmol of indium acetylacetonate (In(acac)$_3$), 0.24 mmol of gallium acetylacetonate (Ga(acac)$_3$), 8 mL of dehydrated oleylamine (OLA), and dodecanethiol (DDT; 1.25 mmol, 0.3 mL) were measured, and the reaction vessel was degassed and then purged with a nitrogen atmosphere, after which the temperature was raised to about 50°C, and the lid was opened once to add crystals of thiourea (0.8 mmol, 60.8 mg) to obtain a mixture. Subsequently, the thus obtained mixture was degassed for a very short time, and the temperature was raised to 150°C at a temperature increase rate of 10°C/min. After the temperature reached 150°C in an actual measurement, a heat treatment was continued for 60 seconds. The reaction vessel was then rapidly cooled by immersion in 50°C water to quench the synthesis reaction. In the early stage of this rapid cooling, the temperature was lowered at an average rate of about 40°C/min. After removing coarse particles by centrifugation, 9 mL of methanol was added to the resulting supernatant to induce precipitation of semiconductor nanoparticles, which were subsequently recovered by centrifugation. The thus recovered solid was dispersed in 5 mL of hexane.

In a reaction vessel, 3.3 mL of the above-synthesized hexane dispersion of semiconductor nanoparticles was measured as a dispersion of semiconductor nanoparticles, and 0.2 mmol of gallium acetylacetonate (Ga(acac)$_3$), 0.3 mmol of 1,3-dimethylthiourea, and 36.5 mmol of tetradecylamine were added thereto to obtain a mixture. The thus obtained mixture was vacuum-degassed, and the temperature thereof was raised to 50°C to dissolve tetradecylamine while removing hexane by vaporization. Subsequently, the mixture was purged with a nitrogen atmosphere, and the temperature was raised to 270°C (at a temperature increase rate of 10°C/min) and maintained for 1 hour after reaching 270°C. The mixture was then allowed to cool to about 100°C, and cooling was continued to about 60°C while vacuum-degassing the reaction vessel to remove by-products such as a volatile sulfur compound. To the resulting reaction solution, 3 mL of hexane was added, and this was followed by centrifugation to remove coarse particles. Then, 8 mL of methanol was added, and the resultant was centrifuged to precipitate and remove particles having a large particle size, after which 12 mL of methanol was further added to the resulting supernatant to induce precipitation of semiconductor nanoparticles, which were subsequently recovered by centrifugation and washed with 10 mL of methanol. Thereafter, the thus obtained semiconductor nanoparticles were dispersed in 3 mL of hexane. For the thus obtained semiconductor nanoparticles, the results of measuring the emission spectrum in the same manner as in Example 1 are shown in Table 1. In addition, the relative emission intensity spectrum of the thus obtained semiconductor nanoparticles, which was normalized by the maximum emission intensity of the semiconductor nanoparticles of Example 1, is shown in FIG. 1.

(Example 2)

First Step

A first mixture was obtained by mixing 0.1 mmol of silver ethyl xanthate (Ag(EX)), 0.12 mmol of indium acetate (In(OAc)$_3$), 0.2 mmol of gallium ethyl xanthate (Ga(EX)$_3$), and 0.010 mmol of gallium chloride with 20 mL of oleylamine. This first mixture was heat-treated at 260°C for 120 minutes with stirring in a nitrogen atmosphere. The thus obtained suspension was allowed to cool and then centrifuged (radius: 146 mm, at 3,800 rpm for 5 minutes), and the resulting precipitate was removed to obtain a dispersion of first semiconductor nanoparticles.

Second Step

Subsequently, 10 mL of the thus obtained dispersion containing 0.02 mmol of the first semiconductor nanoparticles in terms of nanoparticle concentration was mixed with 0.07 mmol of gallium chloride ($GaCl_3$) to obtain a second mixture. The pressure was reduced while stirring the second mixture, and the temperature was raised to 80°C to perform a heat treatment at 80°C for 10 minutes with the reduced pressure being maintained. Then, the temperature was further raised to 260°C in a nitrogen atmosphere to perform a heat treatment for 120 minutes. Thereafter, the resulting suspension was allowed to cool to obtain a dispersion of second semiconductor nanoparticles. For the thus obtained second semiconductor nanoparticles, the results of measuring the emission spectrum in the same manner as in Example 1 are shown in Table 1 and FIG. 2.

(Example 3)

A dispersion of second semiconductor nanoparticles was obtained in the same manner as in Example 2, except that the amount of gallium chloride in the first mixture obtained in the first step was changed to 0.020 mmol. For the thus obtained second semiconductor nanoparticles, the results of measuring the emission spectrum in the same manner as in Example 1 are shown in Table 1. In addition, the relative emission intensity spectrum normalized by the maximum emission intensity of the semiconductor nanoparticles of Example 2 is shown in FIG. 2.

(Example 4)

A dispersion of second semiconductor nanoparticles was obtained in the same manner as in Example 2, except that the amount of gallium chloride in the first mixture obtained in the first step was changed to 0.015 mmol. For the thus obtained second semiconductor nanoparticles, the results of measuring the emission spectrum in the same manner as in Example 1 are shown in Table 1. In addition, the relative emission intensity spectrum normalized by the maximum emission intensity of the semiconductor nanoparticles of Example 2 is shown in FIG. 2.

(Example 5)

A dispersion of second semiconductor nanoparticles was obtained in the same manner as in Example 2, except that the amount of gallium chloride in the first mixture obtained in the first step was changed to 0.050 mmol. For the thus obtained second semiconductor nanoparticles, the results of measuring the emission spectrum in the same manner as in Example 1 are shown in Table 1. In addition, the relative emission intensity spectrum normalized by the maximum emission intensity of the semiconductor nanoparticles of Example 2 is shown in FIG. 2.

(Example 6)

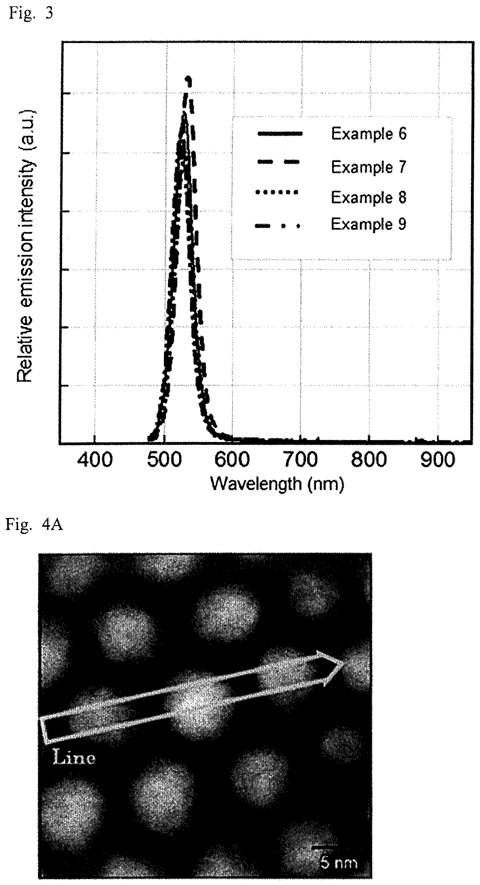

A dispersion of second semiconductor nanoparticles was obtained in the same manner as in Example 2, except that, in the first step, a first mixture was obtained by mixing 0.04 mmol of silver ethyl xanthate (Ag(EX)), 0.048 mmol of indium acetate ($In(OAc)_3$), 0.08 mmol of gallium ethyl xanthate ($Ga(EX)_3$), and 0.008 mmol of gallium chloride with 20 mL of oleylamine. For the thus obtained second semiconductor nanoparticles, the results of measuring the emission spectrum in the same manner as in Example 1 are shown in Table 1 and FIG. 3.

(Example 7)

A dispersion of second semiconductor nanoparticles was obtained in the same manner as in Example 6, except that the amount of gallium chloride in the first mixture obtained in the first step was changed to 0.016 mmol. For the thus obtained second semiconductor nanoparticles, the results of measuring the emission spectrum in the same manner as in Example 1 are shown in Table 1. In addition, the relative emission intensity spectrum normalized by the maximum emission intensity of the semiconductor nanoparticles of Example 6 is shown in FIG. 3.

(Example 8)

A dispersion of second semiconductor nanoparticles was obtained in the same manner as in Example 2, except that, in the first step, a first mixture was obtained by mixing 0.06 mmol of silver ethyl xanthate (Ag(EX)), 0.072 mmol of indium acetate (In(OAc)$_3$), 0.12 mmol of gallium ethyl xanthate (Ga(EX)$_3$), and 0.012 mmol of gallium chloride with 20 mL of oleylamine. For the thus obtained second semiconductor nanoparticles, the results of measuring the emission spectrum in the same manner as in Example 1 are shown in Table 1. In addition, the relative emission intensity spectrum normalized by the maximum emission intensity of the semiconductor nanoparticles of Example 6 is shown in FIG. 3.

(Example 9)

A dispersion of second semiconductor nanoparticles was obtained in the same manner as in Example 2, except that, in the first step, a first mixture was obtained by mixing 0.14 mmol of silver ethyl xanthate (Ag(EX)), 0.168 mmol of indium acetate (In(OAc)$_3$), 0.28 mmol of gallium ethyl xanthate (Ga(EX)$_3$), and 0.028 mmol of gallium chloride with 20 mL of oleylamine. For the thus obtained second semiconductor nanoparticles, the results of measuring the emission spectrum in the same manner as in Example 1 are shown in Table 1. In addition, the relative emission intensity spectrum normalized by the maximum emission intensity of the semiconductor nanoparticles of Example 6 is shown in FIG. 3.

[Table 1]

| | Synthesis conditions for the first semiconductor nanoparticles | | | | | | | | | Emission characteristics | | | |
|---|---|---|---|---|---|---|---|---|---|---|---|---|---|
| | Ag(EX) (mmol) | Ag(OAc) (mmol) | In(OAc)$_3$ (mmol) | In(acac)$_a$ (mmol) | Ga(E)$_3$, (mmol) | Ga (acac)$_3$ (mmol) | GaCl$_3$ (mmol) | OLA (ml) | DDT (ml) | Peak emission wavelength (nm) | Half width (nm) | Band-edge emission purity (%) | Quantum yield (%) |
| Example 1 | 0.1 | - | 0.12 | - | 0.2 | - | 0.020 | 20 | - | 528 | 33 | 78 | 18 |
| Comparative Example 1 | - | 0.4 | - | 0.16 | - | 0.24 | - | 8 | 0.3 | 554 | 34 | 73 | 20 |
| Example 2 | 0.1 | - | 0.12 | - | 0.2 | - | 0.010 | 20 | - | 519 | 33 | 84 | 58 |
| Example 3 | 0.1 | - | 0.12 | - | 0.2 | - | 0.020 | 20 | - | 529 | 32 | 97 | 84 |
| Example 4 | 0.1 | - | 0.12 | - | 0.2 | - | 0.015 | 20 | - | 523 | 32 | 92 | 81 |
| Example 5 | 0.1 | - | 0.12 | - | 0.2 | - | 0.050 | 20 | - | 528 | 31 | 95 | 64 |
| Example 6 | 0.04 | - | 0.048 | - | 0.08 | - | 0.008 | 20 | - | 529 | 33 | 97 | 63 |
| Example 7 | 0.04 | - | 0.048 | - | 0.08 | - | 0.016 | 20 | - | 534 | 32 | 96 | 87 |
| Example 8 | 0.06 | - | 0.072 | - | 0.12 | - | 0.012 | 20 | - | 530 | 32 | 97 | as |
| Example 9 | 0.14 | - | 0.168 | - | 0.28 | - | 0.028 | 20 | - | 525 | 32 | 95 | 77 |

According to Table 1, in Example 1, semiconductor nanoparticles exhibiting band-edge emission with an emission peak wavelength in a range of 480 nm to 560 nm and a high band-edge emission purity were obtained by one-pot synthesis; therefore, one-pot synthesis was confirmed to be a more efficient production method than the method of Comparative Example 1.

According to Table 1, in Examples 2 to 9, semiconductor nanoparticles exhibiting a higher band-edge emission purity and a higher internal quantum yield were obtained as compared to Example 1.

Scanning Transmission Electron Microscope (STEM)-Energy Dispersive X-ray Analysis (XDS)

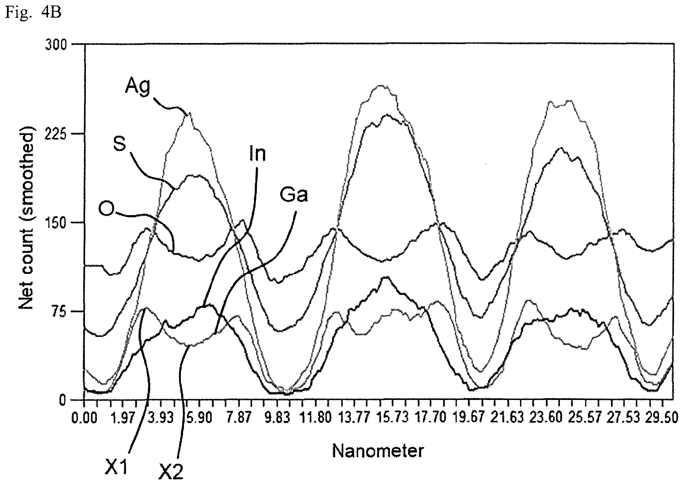

For the semiconductor nanoparticles obtained in Example 2, a line analysis of the composition was performed along the diameter direction of the semiconductor nanoparticles using a multifunctional electron microscope (JEM-F200, manufactured by JEOL, Ltd.) equipped with a dry SD detector under the below-described conditions. The trajectory of the line analysis and the result of the composition analysis are shown in FIGs. 4A and 4B, respectively. In FIG. 4B, the intensity of the characteristic X-ray originating from Ga in a predetermined region of the second semiconductor is indicated as X1, and the intensity of the characteristic X-ray originating from Ga in a predetermined region of the first semiconductor is indicated as X2.

Measurement Conditions

STEM accelerating voltage: 80 kV;
EDX accelerating voltage: 80 kV, resolution: $256 \times 256$, frame time: 5 sec, number of frames: 500

As shown in FIG. 4B, the intensity of the characteristic X-ray originating from Ga in vicinity of the surfaces of the semiconductor nanoparticles was higher than the intensity of the characteristic X-ray originating from Ga in vicinity of the centers of the semiconductor nanoparticles.

The disclosure of Japanese Patent Application No. 2021-036717 (filing date: March 8, 2021) is hereby incorporated by reference in its entirety. All the documents, patent applications, and technical standards that are described in the present specification are hereby incorporated by reference to the same extent as if each individual document, patent application, or technical standard is concretely and individually described to be incorporated by reference.

**Claims**

1. A method of producing semiconductor nanoparticles, the method comprising performing a first heat treatment of a first mixture, which comprises a silver (Ag) salt, an indium (In) salt, a compound having a gallium-sulfur (Ga-S) bond, a gallium halide, and an organic solvent, to obtain first semiconductor nanoparticles.

2. The method of producing semiconductor nanoparticles according to claim 1, wherein, in the first mixture, a content molar ratio of the gallium halide with respect to the Ag salt is 0.01 to 1.

3. The method of producing semiconductor nanoparticles according to claim 1 or 2, wherein the concentration of the Ag salt in the first mixture is 0.01 mmol/L to 500 mmol/L.

4. The method of producing semiconductor nanoparticles according to any one of claims 1 to 3,
   wherein the first heat treatment is performed at 200°C or higher and 320°C or lower.

5. The method of producing semiconductor nanoparticles according to any one of claims 1 to 4,
   wherein the gallium halide in the first mixture comprises gallium chloride.

6. The method of producing semiconductor nanoparticles according to any one of claims 1 to 5, wherein the Ag salt in the first mixture comprises a compound having an Ag-S bond.

7. The method of producing semiconductor nanoparticles according to any one of claims 1 to 6, the method further comprising performing a second heat treatment of a second mixture, which comprises the first semiconductor nanoparticles and a gallium halide, to obtain second semiconductor nanoparticles.

8. The method of producing semiconductor nanoparticles according to claim 7, wherein, in the second mixture, a molar ratio of the gallium halide with respect to the first semiconductor nanoparticles is 0.1 to 10.

9. The method of producing semiconductor nanoparticles according to claim 7 or 8, wherein the gallium halide in the second mixture comprises gallium chloride.

10. The method of producing semiconductor nanoparticles according to any one of claims 7 to 9, wherein the second heat treatment is performed at 200°C or higher and 320°C or lower.

11. Semiconductor nanoparticles comprising a first semiconductor that comprises silver (Ag), indium (In), gallium (Ga), and sulfur (S), wherein

a second semiconductor comprising Ga and S is arranged on a surface of the semiconductor nanoparticle,
the semiconductor nanoparticles exhibit band-edge emission with an emission peak wavelength in a wavelength range of 475 nm to 560 nm when irradiated with a light having a wavelength of 365 nm,
the band-edge emission purity is 70% or higher,
the internal quantum yield of the band-edge emission is 15% or more, and
in an energy dispersive X-ray analysis, the intensity of a characteristic X-ray originating from Ga of the second semiconductor is higher than the intensity of a characteristic X-ray originating from Ga of the first semiconductor.

12. The semiconductor nanoparticles according to claim 11, wherein a ratio of a maximum value of the intensity of the characteristic X-ray originating from Ga of the second semiconductor with respect to a minimum value of the intensity of the characteristic X-ray originating from Ga of the first semiconductor is 1.1 to 3.

13. The semiconductor nanoparticles according to claim 11 or 12, wherein an emission spectrum of the semiconductor nanoparticles has a full width at half maximum of 45 nm or less.

14. The semiconductor nanoparticles according to any one of claims 11 to 13, wherein the surface of the semiconductor nanoparticle is modified with a gallium halide.

15. A light emitting device, comprising:

a light conversion member comprising the semiconductor nanoparticles according to any one of claims 11 to 14; and
a semiconductor light emitting element.

16. The light emitting device according to claim 15, wherein the semiconductor light emitting element is an LED chip.

Fig. 1

Fig. 2

Fig. 3

Fig. 4A

Fig. 4B

**INTERNATIONAL SEARCH REPORT**

| International application No. |
| --- |
| **PCT/JP2022/009144** |

**A. CLASSIFICATION OF SUBJECT MATTER**

*C09K 11/00*(2006.01)i; *C09K 11/62*(2006.01)i; *B82Y 20/00*(2011.01)i; *B82Y 40/00*(2011.01)i; *H01L 33/50*(2010.01)i
FI: H01L33/50; B82Y20/00; B82Y40/00; C09K11/00 B; C09K11/00 G; C09K11/62 ZNM

According to International Patent Classification (IPC) or to both national classification and IPC

**B. FIELDS SEARCHED**

Minimum documentation searched (classification system followed by classification symbols)

H01L33/00-33/64; C09K11/00-11/89; B82Y20/00; B82Y40/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2020/257510 A1 (NANOSYS, INC.) 24 December 2020 (2020-12-24) paragraphs [0075]-[0130], [0172]-[0176], [0187]-[0207], fig. 1-7 | 11-16 |
| A | | 1-10 |
| A | JP 2020-152904 A (TOKAI NATIONAL HIGHER EDUCATION AND RESEARCH SYSTEM) 24 September 2020 (2020-09-24) entire text, all drawings | 1-16 |
| A | WO 2020/162622 A1 (TOKAI NATIONAL HIGHER EDUCATION AND RESEARCH SYSTEM) 13 August 2020 (2020-08-13) entire text, all drawings | 1-16 |
| A | WO 2019/160093 A1 (OSAKA UNIVERSITY) 22 August 2019 (2019-08-22) entire text, all drawings | 1-16 |
| A | WO 2019/160094 A1 (OSAKA UNIVERSITY) 22 August 2019 (2019-08-22) entire text, all drawings | 1-16 |

☑ Further documents are listed in the continuation of Box C.  ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br><br>**28 April 2022** | Date of mailing of the international search report<br><br>**17 May 2022** |
| Name and mailing address of the ISA/JP<br><br>**Japan Patent Office (ISA/JP)**<br>**3-4-3 Kasumigaseki, Chiyoda-ku, Tokyo 100-8915**<br>**Japan** | Authorized officer<br><br><br><br>Telephone No. |

Form PCT/ISA/210 (second sheet) (January 2015)

## INTERNATIONAL SEARCH REPORT

International application No.

**PCT/JP2022/009144**

### C. DOCUMENTS CONSIDERED TO BE RELEVANT

| Category* | Citation of document, with indication, where appropriate, of the relevant passages | Relevant to claim No. |
|---|---|---|
| P, X | WO 2021/182417 A1 (TOKAI NATIONAL HIGHER EDUCATION AND RESEARCH SYSTEM) 16 September 2021 (2021-09-16) paragraphs [0105]-[0179], [0224]-[0245], fig. 13-16 | 1-16 |

Form PCT/ISA/210 (second sheet) (January 2015)

**INTERNATIONAL SEARCH REPORT**
Information on patent family members

International application No.

**PCT/JP2022/009144**

| Patent document cited in search report | | | Publication date (day/month/year) | Patent family member(s) | | | Publication date (day/month/year) |
|---|---|---|---|---|---|---|---|
| WO | 2020/257510 | A1 | 24 December 2020 | US | 2020/0399535 | A1 | |
| | | | | EP | 3973033 | A1 | |
| | | | | JP | 2021-527159 | A | |
| | | | | CN | 113840895 | A | |
| | | | | KR | 10-2021-0036978 | A | |
| JP | 2020-152904 | A | 24 September 2020 | US | 2020/0295227 | A1 | |
| | | | | entire text, all drawings | | | |
| WO | 2020/162622 | A1 | 13 August 2020 | US | 2022/089452 | A1 | |
| | | | | entire text, all drawings | | | |
| | | | | EP | 3922604 | A1 | |
| | | | | CN | 113474291 | A | |
| WO | 2019/160093 | A1 | 22 August 2019 | US | 2021/0040385 | A1 | |
| | | | | entire text, all drawings | | | |
| | | | | CN | 111819267 | A | |
| WO | 2019/160094 | A1 | 22 August 2019 | US | 2021/0083146 | A1 | |
| | | | | entire text, all drawings | | | |
| | | | | CN | 111801298 | A | |
| WO | 2021/182417 | A1 | 16 September 2021 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012212862 A
- JP 2010177656 A
- WO 2018159699 A
- WO 2019160094 A
- WO 2020162622 A
- JP 2021036717 A

**Non-patent literature cited in the description**

- *Chemistry Letters,* 2016, vol. 45, 898-900